# EUROPÄISCHE PATENTSCHRIFT

(11) **EP 0 384 205 B1**
(45) Veröffentlichungstag und Bekanntmachung des Hinweises auf die Patenterteilung: **08.05.1996**
(21) Anmeldenummer: 90102277.2
(22) Anmeldetag: 06.02.1990
(51) Int. Cl.: H04B 10/14

(54) **Eingangsstufe für einen optischen Breitbandempfänger**
Input stage for a broadband optical receiver
Etage d'entrée pour un récepteur optique à large bande

(30) Priorität: 23.02.1989 DE 3905547
(43) Veröffentlichungstag der Anmeldung: 29.08.1990
(73) Patentinhaber: Alcatel SEL Aktiengesellschaft, D-70435 Stuttgart (DE); ALCATEL N.V., NL-1077 XX Amsterdam (NL)
(72) Erfinder: Eichel, Manfred, D-7000 Stuttgart 1 (DE)
(74) Vertreter: Pechhold, Eberhard, Dipl.-Phys.

(56) Entgegenhaltungen:
- US-A- 4 567 446
- OPTICS COMMUNICATIONS, Band 59, heft 5/6, Oktober 1986, Seiten 349-352, Amsterdam, NL; B. BENTLAND: "A 2.4 Gb/s fiber-optic reviever with cascaded monolithic amplifiers"
- J.A. GEISLER et al.: "Optical fibres" - Kapitel 3: "Optical fibre receivers", Seite 460, EPO Applied Technology Series, Band 5, 1986, Pergamon Press, Oxford, Gb

## Beschreibung

Die Erfindung betrifft eine Eingangsstufe für einen optischen Breitbandempfänger gemäß dem Oberbegriff des Patentanspruchs 1.

In solchen Eingangsstufen werden Vorverstärker z.B. zusammen mit PIN- oder Avalanche-Photodioden eingesetzt, um über Lichtwellenleiter übertragene, hochfrequente optische Signale in zur Demodulation geeignete elektrische Signale umzuwandeln.

Eine Übersicht über mit PIN-Photodioden oder Avalanche-Photodioden (APD) ausgerüstete gebräuchliche Eingangsstufen (Front ends) ist z.B. in "EPO Applied Technologie Series, Vol. 5" mit dem Titel "Optical Fibres" in Chapter III, Seite 446 ff enthalten.

Mit solchen Eingangsstufen soll über einen möglichst breiten Frequenzbereich hinweg eine weitgehend lineare und möglichst hohe Verstärkung, die ein gutes Signal-Rausch-Verhältnis voraussetzt, erreicht werden.

Die besten Ergebnisse wurden bisher mit Avalanche-Photodioden zusammen mit Vorverstärkern erreicht, die einen Galliumarsenid-Feldeffekttransistor (GaAsFET) als Eingangsstufe verwendeten und als Transimpedanzverstärker ausgeführt waren. Avalanche-Photodioden sind jedoch gegenüber PIN-Dioden auch heute noch sehr teuer und Feldeffekttransistoren, vor allem kapazitätsarme GaAs-Feldeffekttransistoren weisen ein hohes sogenanntes 1/f-Rauschen im niedrigen Frequenzbereich auf. Letzteres wirkt sich z.B. bei der zusätzlichen übertragung niedrigfrequenter Signale oder der übertragung von Analogsignalen störend aus.

Wie aus "Elektrisches Nachrichtenwesen" Band 56, Nr. 4, 1981, Seite 356, Absatz "Schlußbetrachtungen" hervorgeht, versprach man sich bisher vor allem von der Entwicklung verbesserter Avalanche-Photodioden und der Integration von Detektor und nachgeschaltetem Feldeffekttransistor (PIN-FET-Lösung) Fortschritte bei der Entwicklung optischer Empfänger.

Aus der eingangs genannten Literaturstelle sind auch mit Bipolar-Transistoren aufgebaute Vorverstärker bekannt, die zusammen mit Avalanche-Photodioden als Detektoren übertragungsraten von 500 Mbit/s (S. 455, Fig. 3.2.3) und 1,12 Gbit/s (S. 460, Fig. 3.4.1) erreicht haben sollen. Nähere Angaben zur Realisierung der wiedergegebenen Schaltungen und den hierfür erforderlichen Aufwand sind dort jedoch nicht zu entnehmen.

Schließlich ist aus Optics Communications, Bd. 59, Heft 5/6, Oktober 1986, Seiten 349 bis 352 ein Faseroptischer Empfänger mit mehreren hintereinandergeschalteten, monolithisch integrierten Verstärkern bekannt. In der dritten von insgesamt vier Verstärkerstufen, die aus Bipolar-Transistoren aufgebaute Darlington-Schaltungen enthalten, ist ein Rückkopplungszweig mit einem RLC-Netzwerk vorgesehen, das eine Ausweitung des nutzbaren Frequenzbereiches bewirkt. Die relativ aufwendige Schaltung wurde mit Hilfe eines speziellen Rechnerprogrammes entwickelt.

Der Erfindung liegt die Aufgabe zugrunde, eine Eingangsstufe für einen optischen Breitbandempfänger zu schaffen, die rauscharm ist, bei möglichst großer Bandbreite und Verstärkung eine gute Linearität in Verstärkung und Phase aufweist und außerdem kostengünstig hergestellt werden kann.

Diese Aufgabe wird durch die im kennzeichnenden Teil des Patentanspruchs 1 angegebenen Merkmale gelöst.

Die Lösung ermöglicht den Aufbau hochwertiger Eingangsstufen für optische Empfänger mit Hilfe von einfachsten, kostengünstigen, auf dem Markt erhältlichen integrierten Schaltkreisen. Eine aus Bipolar-Transistoren aufgebaute Darlington-Schaltung für den UHF-Bereich, die sich für den Aufbau einer Eingangsstufe gemäß der Erfindung eignet, ist z.B. aus der Firmendruckschrift "MAR-Verstärker, DC-2 GHz" der Firma Industrie-Electronics GmbH, Frankfurt, bekannt. Wie in Versuchen festgestellt wurde, läßt sich die Linearität dieser Schaltung durch Zuschalten eines passend bemessenen Transimpedanzwiderstandes so weit verbessern, daß sie zusammen mit einer Avalanche-Photodiode im Frequenzbereich von 0 bis 5 GHz eingesetzt werden kann und dabei, was die erreichbare Verstärkung und den Signal-Rausch-Abstand anbetrifft, bekannte GaAs-FET-Schaltungen übertrifft. Infolge der Verwendung von Bipolar-Transistoren anstelle von Feldeffekt-Transistoren entfällt hier außerdem das bei Feldeffekttransistoren vorhandene 1/f-Rauschen im niedrigen Frequenzbereich, wodurch z.B. eine zusätzliche optische Übertragung von Telemetrie-Signalen im Niederfrequenzbereich möglich wird. Selbst bei Verwendung kostengünstiger PIN-Dioden anstelle von Avalanche-Photodioden läßt sich die erfindungsgemäße Eingangsstufe bei guter Verstärkung und Linearität für optische Übertragungsstrecken kurzer und mittlerer Länge problemlos einsetzen.

Ausgestaltungen der Eingangsstufe nach der Erfindung sind in den Unteransprüchen 2 bis 5 angegeben.

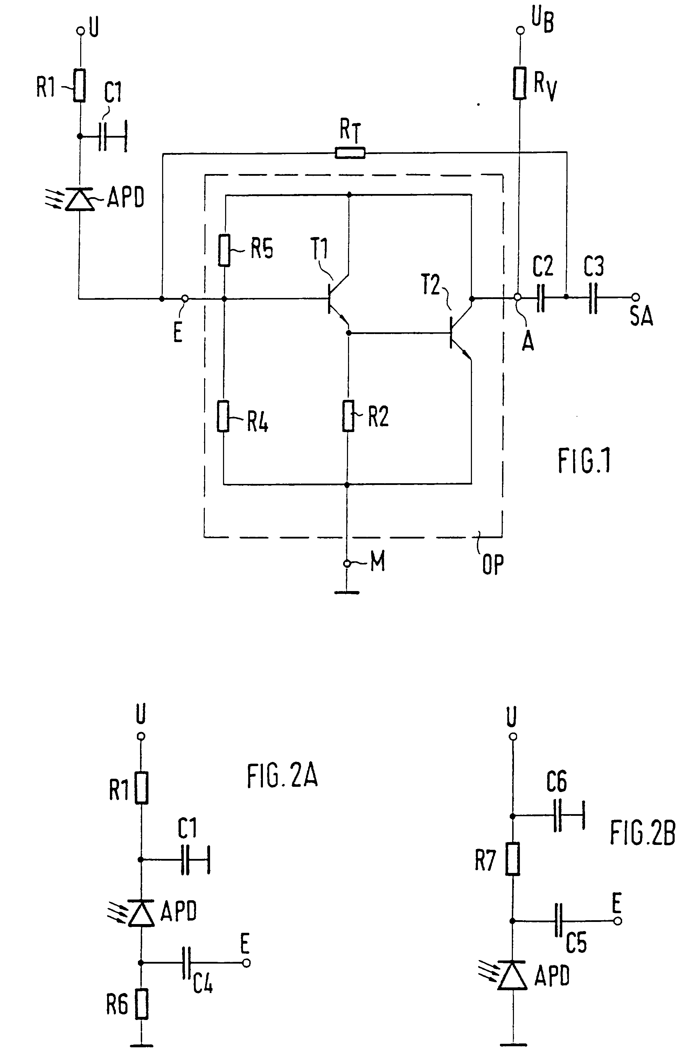

Ein in der anliegenden Fig. 1 wiedergegebenes Ausführungsbeispiel des Vorverstärkers nach der Erfindung verwendet eine Avalanche-Photodiode (APD) oder eine PIN-Diode zusammen mit der in der oben angegebenen Firmendruckschrift beschriebenen integrierten Darlington-Schaltung "Mar 8".

Fig. 2 zeigt zwei weitere Möglichkeiten für die Ankopplung des Lichtdetektors.

In Fig. 1 ist eine Avanlanche-Photodiode (APD) kathodenseitig über einen Vorwiderstand R1 an den positiven Pol einer Betriebsspannung U (Gegenpol an Masse) angeschlossen, deren Höhe an den jeweils verwendeten Detektor angepaßt ist. Ein gegen Masse geschalteter Kondensator C1 stellt den zum Betrieb der APD erforderlichen kathodenseitigen HF-Kurzschluß her. Die Anode der APD ist direkt mit dem Eingang E eines integrierten Verstärkers OP mit dem Ausgangsanschluß A und dem Masseanschluß M verbunden, der zwei in Darlington-Schaltung angeordnete Bipolartransistoren T1 und T2 aufweist. Der Arbeitspunkt des integrierten Verstärkers ist durch sein internes Widerstandsnetzwerk bestimmt. Dieses besteht aus einem gegen Masse M geschalteten Emitterwiderstand R2 des Transistors T1 und einem eingangsseitigen hochohmigen Spannungsteiler aus einem gegen Masse geschalteten Basiswiderstand R4 des ersten Transistors T1 und einem gegen positives Potential geschalteten Widerstand R5, der mit dem den Ausgang A des integrierten Verstärkers bildenden Kollektor des zweiten Transistors T2 verbunden ist. Der Mittelabgriff des Spannungsteilers ist mit der Basis des ersten Transistors T1 verbunden und bildet gleichzeitig den Eingang E der integrierten Verstärkerschaltung. Die Speisung des integrierten Verstärkers erfolgt durch eine an seinen Ausgang A gegenüber Masse angelegte Gleichspannung, die einer Speisespannungsquelle U_{B} über einen Vorwiderstand R_{V} entnommen wird.

Die in Fig. 1 dargestellte Schaltung weist weiterhin einen Transimpedanzwiderstand R_{T} auf, der den Eingang E des integrierten Verstärkers OP wechselspannungsmäßig mit dessen Ausgang und dem Ausgang SA der gesamten Eingangsstufe verbindet. Über Kondensatoren C2 und C3 ist der Transimpedanzwiderstand sowohl gegenüber dem Ausgang A des integrierten Verstärkers als auch gegenüber dem Schaltungsausgang SA gleichspannungsmäßig entkoppelt. Diese Entkopplung kann auch gegenüber dem Eingang E des integrierten Verstärkers vorgenommen werden.

Der Transimpedanzwiderstand R_{T} hat einen Wert von z.B. 750 Ω und ist damit viel kleiner als der bereits intern im integrierten Verstärker vorhandene Widerstand R5, der einen Wert von ca. 10 K Ω aufweist und nur der Arbeitspunkteinstellung des integrierten Verstärkers dient.

Erst aufgrund des Widerstandes R_{T} nimmt der integrierte Verstärker die für einen Transimpedanzverstärker typischen Merkmale wie lineare Verstärkung über einen breiten Frequenzbereich und geringes Rauschen an.

Fig. 2 zeigt zwei Ankopplungsmöglichkeiten für den optischen Detektor APD.

In Fig. 2a ist die Anodenseite des Detektors APD, im Gegensatz zur Darstellung in Fig. 1,. kapazitiv über einen Kondensator C4 an den Eingang E des nicht dargestellten integrierten Verstärkers angekoppelt. Damit Gleichspannung an der APD anliegt, ist deren Anode zusätzlich über einen Widerstand R6 an Masse gelegt.

In Fig. 2b liegt die Anode der APD direkt an Masse. Der Eingang E des integrierten Verstärkers ist an die Kathode der APD über einen Kondensator C5 kapazitiv angekoppelt. Das vom integrierten Verstärker zu verarbeitende Signal ist deshalb gegenüber dem in Schaltungen gemäß Fig. 1 und Fig. 2a dem integrierten Verstärker zugeführten Signal invertiert. Die Betriebsspannung wird über einen Vorwiderstand R7 zugeführt. Der HF-Kurzschluß durch einen gegen Masse geschalteten Kondensator C6 befindet sich zwischen Vorwiderstand und Betriebsspannungsanschluß U.

Mit der in Fig. 1 dargestellten Schaltung wird eine so gute Verstärkung erreicht, daß noch eine Lichtleistung von - 32,5 dBm ausreicht, um über eine 3dB-Bandbreite von 2,4 GHz bei guter Linearität eine Bitfehlerrate von 10⁻⁹ sicherzustellen. Das Rauschen ist über den gesamten Frequenzbereich hinweg gering (ca. 3,5 dB).

Wird anstelle einer APD eine kostengünstige PIN-Diode eingesetzt, so ist eine Lichtleistung von - 20 dBm erforderlich, um die angegebenen Werte zu erreichen.

## Patentansprüche

1. Eingangsstufe für einen optischen Breitbandempfänger mit einer Avalanche-Photodiode (APD) oder PIN-Diode als Lichtdetektor und einem nachgeschalteten, aus einer monolithisch integrierten, aus Bipolar-Transistoren aufgebauten Darlington-Schaltung (OP) bestehenden Vorverstärker,
**dadurch gekennzeichnet**, daß der Vorverstärker durch einen Transimpedanzwiderstand (R_{T}) überbrückt ist, der einen Wert zwischen 100 Ω und 1500 Ω aufweist und an die Darlington-Schaltung kapazitiv angekoppelt ist.

2. Eingangsstufe nach Anspruch 1, dadurch gekennzeichnet, daß die Darlington-Schaltung zwei Transistorstufen (T1, T2) aufweist.

3. Eingangsstufe nach einem der vorstehenden Ansprüche, dadurch gekennzeichnet, daß die APD oder PIN-Diode mit ihrer Anodenseite direkt mit dem Eingang (E) des Vorverstärkers verbunden ist.

4. Eingangsstufe nach einem der Ansprüche 1 oder 2, dadurch gekennzeichnet, daß der Eingang (E) des Vorverstärkers mit der über einen ohmschen Widerstand (R6) gegen Masse geschalteten Anode der APD oder PIN-Diode kapazitiv gekoppelt ist.

5. Eingangsstufe nach einem der Ansprüche 1 oder 2, dadurch gekennzeichnet, daß die Anode der APD oder PIN-Diode an Masse gelegt ist und der Eingang (E) des Vorverstärkers mit der über einen ohmschen Widerstand (R7) an einer Speisespannung (U) liegenden Kathodenseite der APD oder PIN-Diode kapazitiv gekoppelt ist.

## Claims

1. A front end for a broadband optical receiver, comprising an avalanche photodiode (APD) or PIN diode as a light detector and a subsequent preamplifier implemented with a monolithic integrated Darlington circuit (OP) constructed from bipolar transistors,
**characterized in** that the preamplifier is bypassed by a transimpedance resistor (R_{T}) which has a value between 100 Ω and 1500 Ω and is capacitively coupled to the Darlington circuit.

2. A front end as claimed in claim 1, characterized in that the Darlington circuit contains two transistor stages (T1, T2).

3. A front end as claimed in any one of the preceding claims, characterized in that the APD or PIN diode has its anode connected directly to the input (E) of the preamplifier.

4. A front end as claimed in claim 1 or 2, characterized in that the input (E) of the preamplifier is capacitively coupled to the anode of the APD or PIN diode, said anode being grounded through a resistor (R6).

5. A front end as claimed in claim 1 or 2, characterized in that the anode of the APD or PIN diode is grounded, and that the input (E) of the preamplifier is capacitively coupled to the cathode of the APD or PIN diode, said cathode being connected through a resistor (R7) to a supply voltage (U).

## Revendications

1. Etage d'entrée pour un récepteur optique à large bande, comportant une photodiode à avalanche (APD) ou une diode PIN comme photodétecteur et un préamplificateur monté en aval, composé d'un circuit Darlington (OP) qui est intégré monolithe et qui est constitué de transistors bipolaires,
caractérisé en ce que le préamplificateur est ponté par une résistance d'adaptation d'impédance (RT) qui présente une valeur comprise entre 100 Ω et 1500 Ω et qui est couplé en régime capacitif au circuit Darlington.

2. Etage d'entrée suivant la revendication 1, caractérisé en ce que le circuit Darlington présente deux étages de transistors (T1, T2).

3. Stage d'entrée suivant l'une des revendications précédentes, caractérisé en ce que l'APD ou diode PIN est reliée directement à l'entrée (E) du préamplificateur par son côté d'anode.

4. Etage d'entrée suivant l'une des revendications 1 ou 2, caractérisé en ce que l'entrée (E) du préamplificateur est couplée en régime capacitif à l'anode de l'APD ou diode PIN, laquelle anode est mise à la masse par une résistance ohmique (R6).

5. Etage d'entrée suivant l'une des revendications 1 ou 2, caractérisé en ce que l'anode de l'APD ou diode PIN est mise à la masse et l'entrée (E) du préamplificateur est couplée en régime capacitif au côté de cathode de l'APD ou diode PIN, ledit côté de cathode étant mis a une tension d'alimentation (U) par une résistance ohmique (R7).
